# FASCICULE DE BREVET EUROPEEN

(11) **EP 4 071 827 B1**
(45) Date de publication et mention de la délivrance du brevet: **09.12.2026**
(21) Numéro de dépôt: 22163716.8
(22) Date de dépôt: 23.03.2022
(51) Int. Cl.: H10D 30/01, H10D 30/69, H10D 64/01, H10P 30/20

(54) **PROCÉDÉ DE RÉALISATION D'UN DISPOSITIF MICROÉLECTRONIQUE**
VERFAHREN ZUR HERSTELLUNG EINER MIKROELEKTRONISCHEN VORRICHTUNG
METHOD FOR PRODUCING A MICROELECTRONIC DEVICE

(30) Priorité: 26.03.2021 FR 2103113
(43) Date de publication de la demande: 12.10.2022
(73) Titulaire: Commissariat à l'Energie Atomique et aux Energies Alternatives, 75015 Paris (FR)
(72) Inventeur: KANYANDEKWE, Joël, 38054 GRENOBLE Cedex 09 (FR); LE ROYER, Cyrille, 38054 GRENOBLE Cedex 09 (FR)
(74) Mandataire: Hautier IP

(56) Documents cités:
- EP-A1- 1 884 985
- WO-A1-2009/017997
- US-A1- 2010 279 479
- US-A1- 2012 068 193

## Description

### DOMAINE TECHNIQUE

La présente invention concerne le domaine de la microélectronique. Elle peut être mise en oeuvre pour réaliser des transistors de type n présentant un canal mécaniquement contraint.

### ETAT DE LA TECHNIQUE

En technologie CMOS, i.e. basée sur des transistors métal-oxyde-semiconducteur complémentaires, les performances des transistors de type n peuvent être améliorées par l'utilisation de canaux mécaniquement contraints en tension, notamment à partir de substrats de type couche mince sur isolant complétement déplétée, par exemple en silicium complétement déplété sur isolant FDSOI (acronyme de Fully Depleted Silicon On Insulator).

La réalisation de canaux mécaniquement contraints en tension peut se faire localement en formant des zones à base de carbure de silicium SiC de part et d'autre des canaux en silicium. Ces zones sont également appelées « stressors ».

Le document « Strained Si Channel MOSFETs with Embedded Silicon Carbon Formed by Solid Phase Epitaxy, Yaocheng Lui et al., Symposium on VLSI Technology Digest of Technical Papers, 2007 » divulgue une solution pour former des zones à base de SiC au niveau des zones source et drain d'un transistor nFET (acronyme de « n-type Field Effect Transistor » pour transistor à effet de champ de type n). Cette solution consiste à implanter du carbone dans les zones source et drain de part et d'autre de la grille et des espaceurs du transistor, puis à procéder à une épitaxie en phase solide SPE (acronyme de « solid-phase epitaxy » pour épitaxie en phase solide) du SiC. Cela permet d'induire une tension dans le canal, de l'ordre de 615 MPa.

Un inconvénient de cette solution est que la contrainte en tension n'est pas suffisante pour augmenter significativement les performances des transistors nFET. Le document cité ci-dessus suggère de combiner la formation de SiC au niveau des zones source et drain décrite ci-dessus avec une étape de formation d'une couche contrainte typiquement connue sous l'appellation « stress liner ».

L'intérêt de recourir à la formation d'un « stressor » à base de SiC est dès lors limité. Le document EP1884985 A1 décrit un procédé comprenant la formation d'une région amorphe dans un semi-conducteur cristallin, tel que le silicium, jusqu'à une première profondeur, suivie de l'implantation d'un élément de substitution, tel que le carbone, à une profondeur inférieure à la première profondeur.

Il existe donc un besoin consistant à dépasser les limitations des solutions connues.

En particulier, un objet de la présente invention est de proposer un procédé de réalisation de zones à base de SiC permettant d'augmenter une contrainte en tension dans le canal.

### RESUME

Pour atteindre cet objectif, selon un mode de réalisation on prévoit un procédé de formation de zones à base de SiC cristallin de part et d'autre d'un canal de transistor de type N, comprenant :
- Fournir un substrat comprenant une couche à base de silicium présentant une épaisseur e,
- Former au moins un motif de masquage, l'au moins un motif de masquage présentant des ouvertures, lesdites ouvertures correspondant à des zones d'implantation de la couche à base de silicium,
- Amorphiser la couche à base de silicium au travers des ouvertures de l'au moins un motif de masquage, dans les zones d'implantation sur une profondeur d strictement inférieure à l'épaisseur e, de façon à former des zones d'implantation amorphisées dans la couche à base de silicium,
- Implanter du carbone dans les zones d'implantation amorphisées, de préférence sur une profondeur d'implantation inférieure ou égale à la profondeur d d'amorphisation,
- Effectuer un recuit thermique de recristallisation de façon à transformer les zones d'implantation amorphisées en zones à base de SiC cristallin,

Avantageusement, après formation des zones à base de SiC cristallin, le procédé comprend une formation d'une grille de transistor sur la couche à base de silicium, directement en bordure des zones à base de SiC cristallin.

Comme indiqué plus haut, les zones à base de SiC cristallin forment des « stressors » induisant un état de contrainte en tension, typiquement en x et en y selon le repère orthonormé annexé aux figures, dans le silicium environnant. Cet état de contrainte en tension diminue à mesure que l'on s'éloigne du stressor.

Il est ainsi prévu de bénéficier au maximum de l'état de contrainte induit par ces stressors, en formant la grille du transistor directement en bordure desdits stressors. L'état de contrainte en tension maximal obtenu se trouve ainsi directement sous la grille. Le canal en silicium du transistor, qui est par définition situé sous ladite grille, bénéficie donc pleinement de cet état de contrainte en tension maximal généré par les stressors.

Contrairement à la formation des stressors divulguée plus haut, les stressors sont ici au plus près du canal, et s'étendent typiquement sous les espaceurs situés de part et d'autre de la grille.

Par ailleurs, dans le procédé selon l'invention, la grille de transistor est avantageusement formée après la formation des zones à base de SiC cristallin. Cela permet d'éviter de soumettre la grille de transistor au recuit thermique de recristallisation nécessaire pour la transformation des zones d'implantation amorphisées en zones à base de SiC cristallin. La grille de transistor est ainsi préservée d'un potentiel endommagement lié à ce type de recuit. Contrairement à l'approche citée plus haut dans le document « Strained Si Channel MOSFETs with Embedded Silicon Carbon Formed by Solid Phase Epitaxy, Yaocheng Lui et al., Symposium on VLSI Technology Digest of Technical Papers, 2007 », la grille de transistor est ici protégée.

Le procédé permet donc de former des transistors nFET à canaux contraints en tension plus performants.

Selon une possibilité avantageuse, le procédé comprend également la formation de source et drains surélevés sur les stressors, de part et d'autre des espaceurs de grille. Ces source et drains surélevés augmentent encore l'état de contrainte en tension initialement généré par les stressors dans le silicium. Le canal en silicium est ainsi encore plus contraint en tension, grâce aux contributions cumulées des stressors et des source et drains surélevés.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1C illustrent schématiquement des étapes d'un procédé de formation de zones à base de SiC cristallin selon un mode de réalisation de la présente invention.
Les figures 1D à 1H illustrent schématiquement des étapes d'un procédé de formation de zones à base de SiC cristallin selon un mode de réalisation de la présente invention.
Les figures 2A à 2E illustrent schématiquement des étapes d'un procédé de formation de zones à base de SiC cristallin selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des différents motifs et reliefs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le procédé comprend en outre une formation d'espaceurs de part et d'autre de la grille de transistor, au moins en partie sur les zones à base de SiC cristallin. Le canal du transistor, situé au droit de la grille, se trouve au plus près des stressors.

Selon un exemple, le procédé comprend en outre une formation par épitaxie de zones source et drains surélevées sur les zones à base de SiC cristallin. Les zones sources et drain surélevées, également appelées RSD (acronyme de « Raised Source Drain »), permettent de réduire les résistances d'accès au transistor. Dans le cadre de l'invention, il a été découvert un effet supplémentaire lié à la formation des RSD. Les RSD permettent d'augmenter la tension dans le canal, de façon synergique avec les stressors. Les RSD exercent en particulier une contrainte selon z, qui semble au moins en partie retransmise dans le canal via les stressors selon x.

Selon un exemple, l'au moins un motif de masquage est à base d'une bicouche de nitrure de silicium et d'oxyde de silicium. Cela permet de protéger efficacement le silicium situé au droit des motifs de masquage et destiné à former des canaux de transistors, lors de l'amorphisation et/ou de l'implantation.

Selon un exemple, l'au moins un motif de masquage est retiré avant formation de la grille de transistor. Cela permet de réaliser une grille de façon standard, typiquement selon un procédé dit « gate first » où la grille fonctionnelle est réalisée avant les espaceurs et de préférence avant les zones source et drain.

Selon un exemple, l'au moins un motif de masquage est conservé de façon à former une grille sacrificielle. Cela permet de réaliser une grille selon un procédé dit « gate last » où la grille fonctionnelle est réalisée après les espaceurs et de préférence après les zones source et drain. Un tel procédé recourt typiquement à une grille sacrificielle.

Selon un exemple, le procédé comprend en outre une formation d'espaceurs de part et d'autre de la grille sacrificielle, au moins en partie sur les zones à base de SiC cristallin. Les espaceurs ne couvrent pas le canal du transistor. Ils sont directement sur les stressors.

Selon un exemple, le procédé comprend en outre, après formation des espaceurs, un retrait de la grille sacrificielle suivi de la formation de la grille de transistor. Cela permet de réaliser une grille fonctionnelle auto-alignée entre les stressors. La définition des grilles est optimisée. Les canaux délimités par les grilles sont directement au contact des stressors.

Selon un exemple, le procédé comprend en outre une étape de formation de tranchées d'isolation avant la formation de l'au moins un motif de masquage.

Selon un exemple, l'au moins un motif de masquage est à base d'une bicouche de silicium polycristallin et d'oxyde de silicium.

Selon un exemple, l'amorphisation se fait par implantation d'ions lourds comme le germanium.

Selon un exemple, l'épaisseur e de la couche à base de silicium et la profondeur d d'amorphisation sont telles que e - d ≥ 2 nm. Cela permet de laisser une fine couche cristalline de silicium sous la couche amorphisée. Cette fine couche cristalline, également appelée « seed » (ou germe en français), permet d'initier la recristallisation lors du recuit de recristallisation ultérieur.

Selon un exemple, l'implantation du carbone se fait selon une profondeur d'implantation inférieure ou égale à la profondeur d d'amorphisation.

Selon un exemple, le recuit thermique de recristallisation est effectué à une température supérieure ou égale à 1100°C.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif. En particulier, les différentes structures (espaceurs, tranchées d'isolation, couche d'encapsulation) illustrées sur les figures peuvent être combinés de manière à former un autre mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un film, une couche, « à base » d'un matériau A, un substrat, un film, une couche comprenant ce matériau A uniquement ou ce matériau A et éventuellement d'autres matériaux, par exemple des éléments d'alliage et/ou des éléments dopants. Ainsi, une couche à base de silicium peut signifier une couche en Si, une couche en Si dopée, une couche en alliage SiGe.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Les termes « latéral », « latéralement » se réfèrent à une direction dans le plan yz.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Les termes « sensiblement », « environ », « de l'ordre de » signifient « à 10% près » ou, lorsqu'il s'agit d'une orientation angulaire, « à 10° près » et de préférence « à 5° près ». Ainsi, une direction sensiblement normale à un plan signifie une direction présentant un angle de 90±10° par rapport au plan.

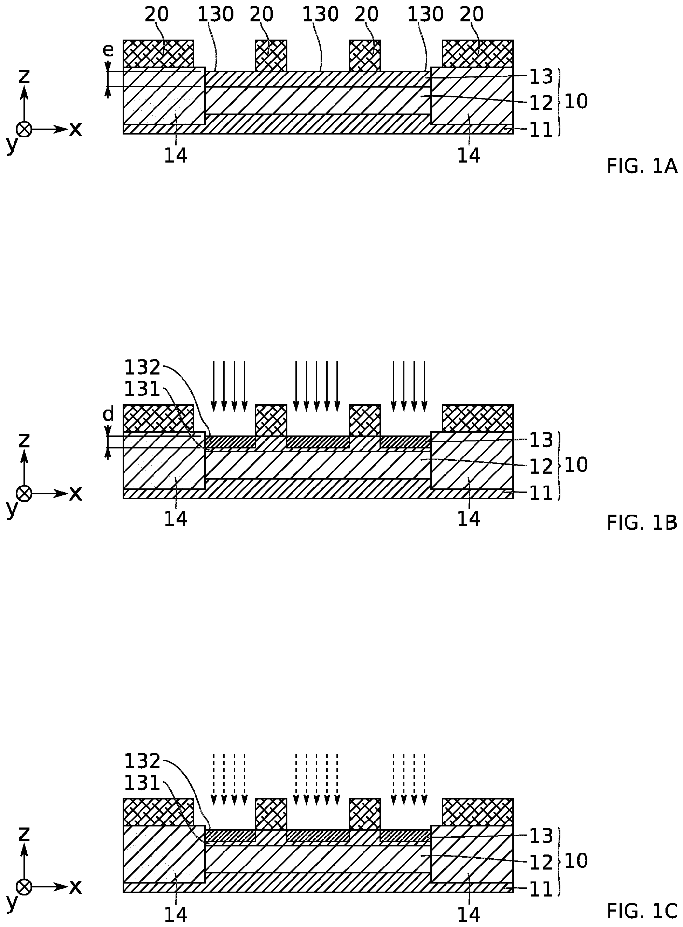

Un premier exemple de mise en œuvre du procédé est illustré aux figures 1A à 1H. Dans cet exemple, la formation des stressors est associée à la formation de grilles de transistor selon un procédé dit « gate first », où l'empilement de grille est conservé après formation des espaceurs.

Comme illustré à la figure 1A, des motifs de masquage 20 sont d'abord formés sur un substrat 10.

Le substrat 10 est de préférence de type silicium sur isolant SOI (acronyme de « Silicon On Insulator »). Un tel substrat 10 SOI comprend, selon la terminologie courante pour l'homme du métier, une couche 11 de silicium épaisse dite « Si bulk », une couche 12 d'oxyde de silicium dite « BOX » (Buried Oxide) et une couche 13 de silicium mince dite « top Si ». L'épaisseur e du top Si 13 peut être typiquement de l'ordre de 10nm à 30nm, par exemple 12nm. L'épaisseur du BOX 12 peut être typiquement comprise entre 20nm et 250nm. Selon une autre possibilité, le substrat 10 peut être un substrat massif « Si bulk ».

Les motifs de masquage 20 présentent de préférence une hauteur h de l'ordre de 30nm à 80nm. Une telle hauteur h permet de protéger efficacement le silicium sous-jacent du top Si 13 lors des étapes d'amorphisation et/ou d'implantation ultérieures.

Les motifs de masquage 20 sont de préférence formés par dépôts successifs d'une couche à base de nitrure de silicium SiN et d'une couche à base d'oxyde de silicium SiO2, ces dépôts étant classiquement suivis par une lithographie et une gravure des couches SiN et SiO2.

Selon un exemple une couche de SiO2 d'épaisseur 5nm à 10nm est formée, par exemple par oxydation thermique ou par dépôt chimique en phase vapeur CVD (acronyme de « Chemical Vapor Deposition »), sur le top Si 13. Une couche de SiN d'épaisseur 10nm à 20nm est ensuite formée par LPCVD (acronyme de « Low Pressure Chemical Vapor Deposition » signifiant dépôt chimique en phase vapeur à basse pression) sur la couche SiO2.

De façon connue, une résine photosensible est ensuite déposée sur la couche SiN, puis structurée par lithographie de façon à définir des motifs en résine surmontant les futurs motifs de masquage 20. Une première gravure de la couche SiN puis une deuxième gravure de la couche SiO2 sont ensuite effectuées au niveau des zones exposées entre les motifs en résine. Ces première et deuxième gravures sont de préférence anisotropes et principalement dirigées selon z. La première gravure peut se faire par voie sèche, typiquement par plasma, par exemple à base d'une chimie NF3/NH3 . La deuxième gravure peut se faire par voie humide, par exemple à partir d'une solution d'acide fluorhydrique (HF) dilué, ou à partir d'une solution d'acide fluorhydrique et d'acide chlorhydrique (HF + HCl). Cette dernière solution permet typiquement d'éliminer la contamination en particules métalliques. Alternativement, la deuxième gravure peut se faire par voie sèche, par exemple par plasma à base d'une chimie HBr/O2.

A l'issue de la deuxième gravure, la surface 130 du top Si 13 est exposée entre les motifs de masquage 20. Les motifs en résine peuvent alors être retirés, par exemple par plasma à base d'd'oxygène O2.

Selon une possibilité, les motifs de masquage 20 comprennent chacun N couches (N=1...3) en empilement selon z. La ou les gravures de ces N couches sont alors adaptées en conséquence.

Comme illustré à la figure 1B, après formation des motifs de masquage 20, une amorphisation partielle du top Si 13 est réalisée à partir de la surface 130 exposée. Cette amorphisation peut typiquement se faire par implantation selon z d'ions lourds, par exemple d'ions germanium Ge⁺⁺, sur une profondeur d. La profondeur d'amorphisation d est choisie strictement inférieure à l'épaisseur e du top Si 13, de façon à laisser un germe 131 de silicium cristallin sous la zone amorphisée 132. Le germe 131 présente ainsi de préférence une épaisseur supérieure ou égale à 2nm après amorphisation (e - d ≥ 2nm). Les paramètres d'implantation des ions lourds, tels que l'énergie, la dose, l'angle d'inclinaison par rapport à z, peuvent être déterminés par des méthodes de Monte-Carlo, typiquement via les simulations bien connues de type SRIM (acronyme de « Stopping and Range of Ions in Matter ») et/ou TRIM (acronyme de « Transport of Ions in Matter »). Un angle d'inclinaison par rapport à z non nul, par exemple de l'ordre de 5° ou 10°, peut ainsi être choisi pour compenser un défaut de verticalité des parois latérales des motifs de masquage 20.

Comme illustré à la figure 1C, une implantation de carbone C dans les zones amorphisées 132a du top Si 13 est réalisée à partir de la surface 130 exposée. Les paramètres d'implantation des ions carbone, tels que l'énergie, la dose, l'angle d'inclinaison par rapport à z, peuvent être déterminés par des méthodes de Monte-Carlo, typiquement via les simulations de type SRIM et/ou TRIM. La dose d'implantation de carbone est typiquement comprise entre 1^{e}15 cm⁻² et 1^{e}20 cm⁻².

Après implantation d'ions carbone, les zones amorphisées 132a sont à base de SiC amorphe.

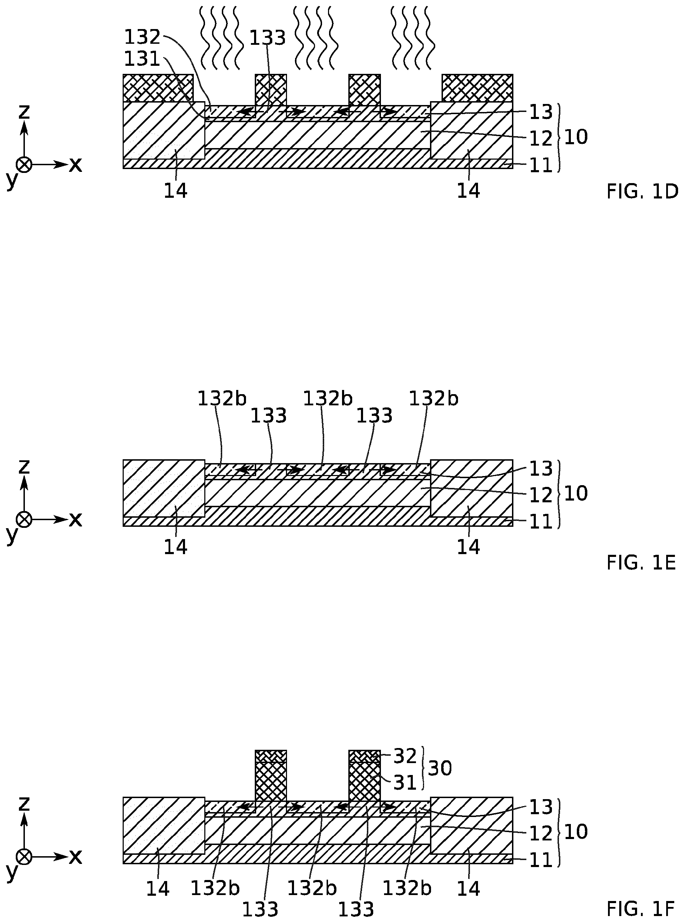

Comme illustré à la figure 1D, un recuit thermique est alors effectué de manière à cristalliser le SiC amorphe. La cristallisation du SiC amorphe se fait typiquement par un mécanisme d'épitaxie en phase solide, à partir du germe 131.

Le recuit thermique peut être un recuit rapide, par exemple de type RTP (acronyme de « Rapid Thermal Processing »). Il est de préférence effectué à une température supérieure ou égale à 1100°C.

Après recuit, les zones 132b sont à base de SiC cristallin. A proximité des zones 132b, également appelées stressors 132b, les zones 133 à base de silicium sont contraintes en tension, typiquement selon un état de contrainte uniaxial selon x, si les motifs de masquage sont des rectangles parallèles dont les côtés sont orientés selon x et y.

Comme illustré à la figure 1E, les motifs de masquage 20 sont ensuite retirés, typiquement par gravure humide à base de H3PO4 et HF. Le top Si 13 comprend alors des stressors 132b et des zones en tension 133, exposées au niveau de la surface 130. Les zones en tension 133 sont destinées à former les canaux de transistors nFET.

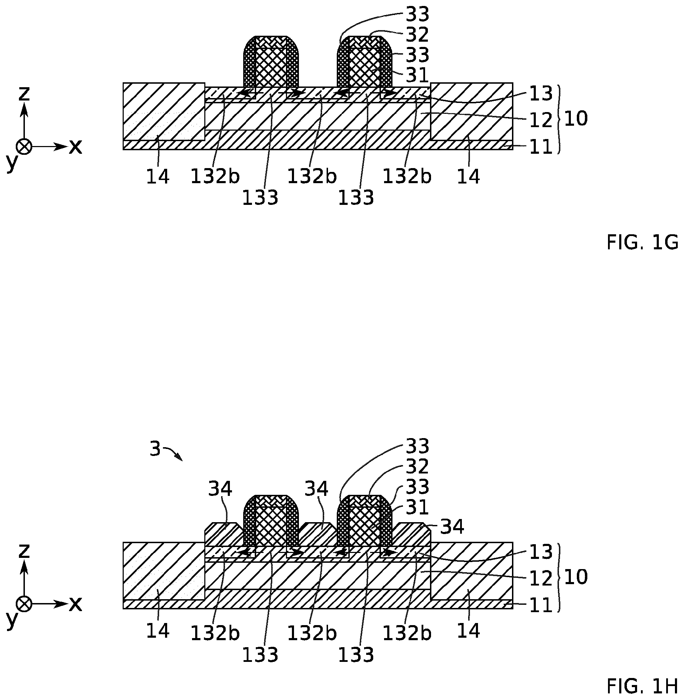

Les figures 1F, 1G, 1H illustrent des étapes classiques de fabrication de ces transistors. En particulier, les empilements de grille 30 sont formés de façon standard par dépôt, lithographie et gravure. Typiquement, les empilements de grille 30 comprennent selon z, à partir de la surface 130, un oxyde de grille (non illustré), une grille 31, par exemple à base de silicium polycristallin, un masque dur 32 (figure 1F). Les masques durs 32 sont ici alignés de façon à se trouver à l'aplomb des zones en tension 133. Les grilles 31 sont ainsi également à l'aplomb des zones en tension 133. Les zones en tension 133 deviennent dès lors les canaux des transistors 3. Les canaux 133 sont ainsi au plus près des stressors 132b.

Selon une possibilité, les empilements de grille 30 sont classiquement isolés les uns vis-à-vis des autres par des tranchées d'isolation superficielles STI 14 (acronyme de « Shallow Trench Insulator »). Cette isolation est effectuée de préférence après la formation des stressors 132b et avant la formation des empilements de grille 30. Il n'est pas nécessaire que le bord du motif de masquage 20 soit aligné avec le bord du STI 14 sous-jacent.

Des espaceurs 33 sont typiquement formés de part et d'autre des empilements de grille 30, sur les flancs latéraux des grilles 31 (figure 1G). Les espaceurs 33 sont ainsi formés sur les stressors 132b.

Les zones source et drain 34 peuvent ensuite être formées de part et d'autre des espaceurs 33. Selon une possibilité avantageuse illustrée à la figure 1H, les zones source et drain 34 sont formées par épitaxie sur les stressors 132b de façon à être surélevées par rapport à la surface 130. Les zones source et drain 34 surélevées peuvent typiquement être à base de silicium dopé. De façon connue, d'autres matériaux sont également envisageables pour former ces zones source et drain 34 surélevées. De telles zones source et drain 34 surélevées induisent avantageusement une contrainte en tension supplémentaire au sein des canaux 133. Cela permet d'augmenter la contrainte totale dans les canaux 133.

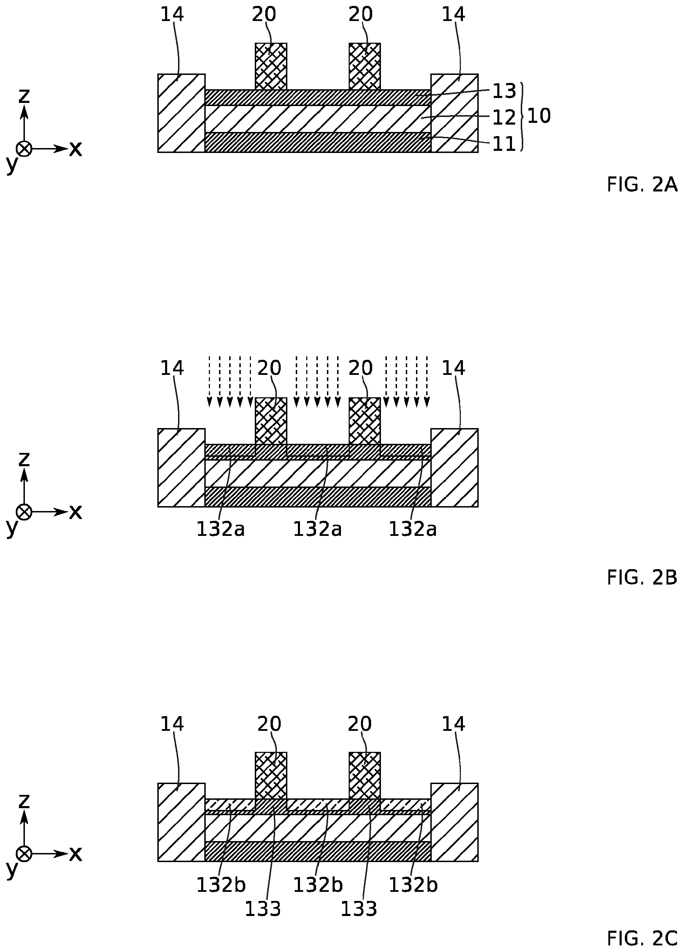

Un deuxième exemple de mise en œuvre du procédé est illustré aux figures 2A à 2E.

Dans cet exemple, le procédé est mis en œuvre après formation des tranchées d'isolation STI 14 (acronyme de « Shallow Trench Insulator ») et des grilles sacrificielles. La formation des stressors est ici associée à la formation de grilles de transistor selon un procédé dit « gate last ». Selon ce procédé « gate last », la grille du transistor est formée après que soient formés les espaceurs, en lieu et place d'un motif également appelé grille sacrificielle. Le remplacement de la grille sacrificielle par une grille « fonctionnelle » se fait de préférence après formation des Source-Drain et des siliciures de contact.

Comme précédemment, des motifs de masquage 20 sont formés sur le substrat 10 (figure 2A). Ces motifs de masquage 20 sont destinés à former des grilles sacrificielles dans la suite du procédé. Ils peuvent être à base de couches de nitrure de silicium et d'oxyde de silicium, comme précédemment. Alternativement ils peuvent être à base de couches de silicium polycristallin et d'oxyde de silicium.

Les motifs de masquage 20 présentent ici de préférence une hauteur h de l'ordre de 40nm à 100nm, de façon à protéger efficacement le silicium sous-jacent du top Si 13 lors des étapes d'amorphisation et/ou d'implantation ultérieures, et de façon à respecter les contraintes dimensionnelles en hauteur d'une grille sacrificielle.

Des zones 132a à base de SiC amorphe sont ensuite formées dans le top Si 13 entre les motifs de masquage 20 comme précédemment, par amorphisation puis implantation de carbone ou par co-implantation d'ions lourds et de carbone (figure 2B).

Un recuit thermique de recristallisation est ensuite effectué comme précédemment de manière à transformer les zones 132a à base de SiC amorphe en zones 132b à base de SiC cristallin, ces dernières formant les stressors 132b (figure 2C).

Dans ce mode de réalisation, les motifs de masquage 20 sont conservés pour former des grilles sacrificielles. Ces grilles sacrificielles sont ainsi auto-alignées avec les zones en tension 133. L'étape d'alignement des grilles vis-à-vis des zones en tension est ainsi avantageusement évitée. L'alignement est facilité.

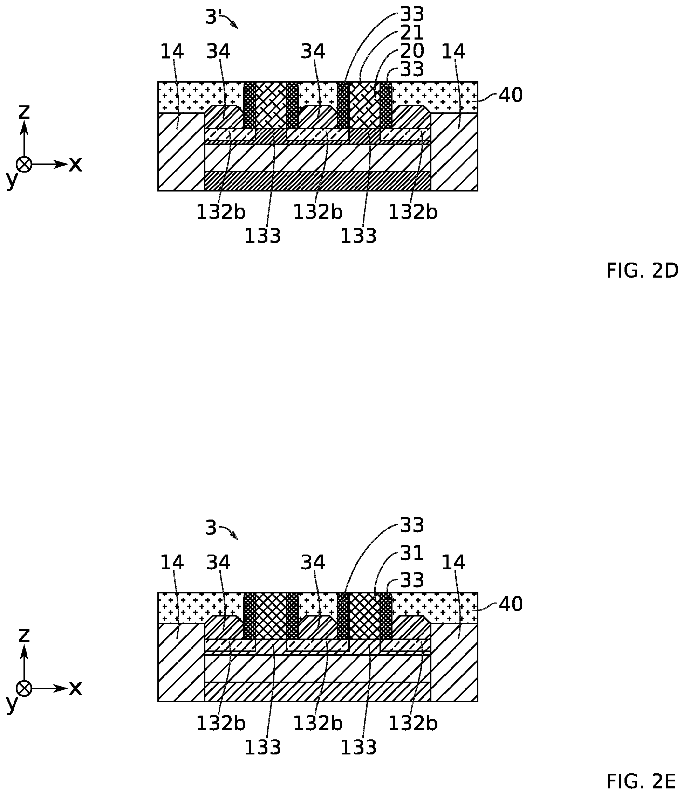

Comme illustré à la figure 2D, les espaceurs 33 sont formés de part et d'autre des grilles sacrificielles 20, sur les stressors 132b. Les zones source et drain surélevées 34 sont ensuite formées de part et d'autre des espaceurs 33, sur les stressors 132b. Une couche d'encapsulation 40 peut être déposée puis planarisée de façon à encapsuler les dispositifs 3' en exposant une face supérieure 21 des grilles sacrificielles 20.

Comme illustré à la figure 2E, les grilles sacrificielles 20 peuvent alors être retirées puis remplacées par des grilles fonctionnelles 31. Ces grilles fonctionnelles 31 comprennent de préférence des portions métalliques, par exemple à base de tungstène et de nitrure de titane W/TiN. Elles sont typiquement séparées des canaux 133 contraints en tension par un matériau à haute constante diélectrique, dit high k. Des transistors 3 nFET sont ainsi formés.

Les étapes connues de siliciuration des zones source et drain et de formation des contacts électriques ne sont pas décrites ici et peuvent être réalisées classiquement.

Ce mode de réalisation « gate last » permet notamment de former des grilles directement alignées sur les canaux contraints en tension, sans difficulté d'alignement.

Au vu de la description qui précède, il apparaît clairement que le procédé proposé offre une solution particulièrement efficace pour réaliser des stressors à base de SiC au plus près des canaux de transistors nFET.

L'invention n'est pas limitée aux modes de réalisations précédemment décrits et s'étend à tous les modes de réalisation couverts par les revendications.

## Revendications

1. Procédé de formation de zones à base de SiC cristallin de part et d'autre d'un canal de transistor de type N, comprenant :
- Fournir un substrat (10) comprenant une couche à base de silicium présentant une épaisseur e,
- Former au moins un motif de masquage (20) sur la couche à base de silicium, d'au moins un motif de masquage présentant des ouvertures, lesdites ouvertures correspondant à des zones d'implantation de la couche à base de silicium,
- Amorphiser la couche à base de silicium à travers les ouvertures de l'au moins un motif de masquage, dans les zones d'implantation, sur une profondeur d strictement inférieure à l'épaisseur e, de façon à former des zones (132) d'implantation amorphisées dans la couche à base de silicium,
- Implanter du carbone dans les zones d'implantation amorphisées (132),
- Effectuer un recuit thermique de recristallisation de façon à transformer les zones d'implantation amorphisées en zones à base de SiC cristallin, le procédé comprenant en outre :
- Après formation des zones à base de SiC cristallin, former une grille (30) de transistor sur la couche à base de silicium, directement en bordure des zones à base de SiC cristallin.

2. Procédé selon la revendication précédente comprenant en outre une formation d'espaceurs de part et d'autre de la grille de transistor, au moins en partie sur les zones à base de SiC cristallin.

3. Procédé selon l'une quelconque des revendications précédentes comprenant en outre une formation par épitaxie de zones source et drains surélevées sur les zones à base de SiC cristallin.

4. Procédé selon l'une quelconque des revendications précédentes dans lequel l'au moins un motif de masquage est à base d'une bicouche de nitrure de silicium et d'oxyde de silicium.

5. Procédé selon l'une quelconque des revendications précédentes dans lequel l'au moins un motif de masquage est retiré avant formation de la grille de transistor.

6. Procédé selon l'une quelconque des revendications 1 à 4, dans lequel l'au moins un motif de masquage est conservé de façon à former une grille sacrificielle.

7. Procédé selon la revendication précédente comprenant en outre une formation d'espaceurs de part et d'autre de la grille sacrificielle, au moins en partie sur les zones à base de SiC cristallin.

8. Procédé selon la revendication précédente comprenant en outre, après formation des espaceurs, un retrait de la grille sacrificielle suivi de la formation de la grille de transistor.

9. Procédé selon l'une quelconque des revendications 6 à 8 comprenant en outre une étape de formation de tranchées d'isolation avant la formation de l'au moins un motif de masquage.

10. Procédé selon l'une quelconque des revendications 6 à 9 dans lequel l'au moins un motif de masquage est à base d'une bicouche de silicium polycristallin et d'oxyde de silicium.

11. Procédé selon l'une quelconque des revendications précédentes dans lequel l'épaisseur e de la couche à base de silicium et la profondeur d d'amorphisation sont telles que e - d ≥ 2 nm.

12. Procédé selon la revendication précédente dans lequel la profondeur d d'amorphisation est inférieure ou égale à 20 nm.

13. Procédé selon l'une quelconque des revendications précédentes dans lequel l'implantation du carbone se fait selon une profondeur d'implantation inférieure ou égale à la profondeur d d'amorphisation.

14. Procédé selon l'une quelconque des revendications précédentes dans lequel l'amorphisation se fait par implantation d'ions lourds comme le germanium.

15. Procédé selon l'une quelconque des revendications précédentes dans lequel le substrat est de type silicium sur isolant (SOI) et comprend une couche d'oxyde enterrée sous la couche à base de silicium d'épaisseur e.

## Patentansprüche

1. Verfahren zum Bilden von Bereichen auf Basis von kristallinem SiC auf beiden Seiten eines N-Typ-Transistorkanals, umfassend:
- Bereitstellen eines Substrats (10), das eine siliziumbasierte Schicht mit einer Dicke e umfasst,
- Bilden mindestens eines Maskierungsmusters (20) auf der siliziumbasierten Schicht, wobei mindestens ein Maskierungsmuster Öffnungen aufweist, wobei die Öffnungen Implantationsbereichen der siliziumbasierten Schicht entsprechen,
- Amorphisieren der siliziumbasierten Schicht durch die Öffnungen des mindestens einen Maskierungsmusters in den Implantationsbereichen bis zu einer Tiefe d, die strikt kleiner als die Dicke e ist, so dass in der siliziumbasierten Schicht amorphisierte Implantationsbereiche (132) gebildet werden,
- Implantieren von Kohlenstoff in den amorphierten Implantationsbereichen (132),
- Durchführen einer thermischen Rekristallisationsglühung, um die amorphierten Implantationsbereiche in Bereiche auf Basis von kristallinem SiC umzuwandeln, wobei das Verfahren ferner umfasst:
- nach dem Bilden der Bereiche auf Basis von kristallinem SiC, Bilden eines Transistor-Gates (30) auf der siliziumbasierten Schicht direkt an dem Rand der Bereiche auf Basis von kristallinem SiC.

2. Verfahren nach dem vorhergehenden Anspruch, ferner umfassend das Bilden von Abstandshaltern auf beiden Seiten des Transistor-Gates, mindestens teilweise auf den Bereichen auf Basis von kristallinem SiC.

3. Verfahren nach einem der vorhergehenden Ansprüche, ferner umfassend das Bilden durch Epitaxie von erhöhten Source- und Drain-Bereichen auf den Bereichen auf Basis von kristallinem SiC.

4. Verfahren nach einem der vorhergehenden Ansprüche, wobei das mindestens eine Maskierungsmuster auf einer Zweischicht aus Siliziumnitrid und Siliziumoxid basiert.

5. Verfahren nach einem der vorhergehenden Ansprüche, wobei das mindestens eine Maskierungsmuster vor dem Bilden des Transistor-Gates entfernt wird.

6. Verfahren nach einem der Ansprüche 1 bis 4, wobei das mindestens eine Maskierungsmuster so beibehalten wird, dass es ein Opfer-Gate bildet.

7. Verfahren nach dem vorhergehenden Anspruch, ferner umfassend das Bilden von Abstandshaltern auf beiden Seiten des Opfer-Gates, mindestens teilweise auf den Bereichen auf Basis von kristallinem SiC.

8. Verfahren nach dem vorhergehenden Anspruch, ferner umfassend, nach dem Bilden der Abstandhalter, das Entfernen des Opfer-Gates gefolgt vom Bilden des Transistor-Gates.

9. Verfahren nach einem der Ansprüche 6 bis 8, ferner umfassend einen Schritt des Bildens von Isolationsgräben vor dem Bilden des mindestens einen Maskierungsmusters.

10. Verfahren nach einem der Ansprüche 6 bis 9, wobei das mindestens eine Maskierungsmuster auf einer Doppelschicht aus polykristallinem Silizium und Siliziumoxid basiert.

11. Verfahren nach einem der vorhergehenden Ansprüche, wobei die Dicke e der siliziumbasierten Schicht und die Amorphisierungstiefe d so sind, dass e - d ≥ 2 nm.

12. Verfahren nach dem vorhergehenden Anspruch, wobei die Amorphisierungstiefe d kleiner oder gleich 20 nm ist.

13. Verfahren nach einem der vorhergehenden Ansprüche, wobei die Implantation des Kohlenstoffs in einer Implantationstiefe erfolgt, die kleiner oder gleich der Amorphisierungstiefe d ist.

14. Verfahren nach einem der vorhergehenden Ansprüche, wobei die Amorphisierung durch Implantation schwerer Ionen wie Germanium erfolgt.

15. Verfahren nach einem der vorhergehenden Ansprüche, wobei das Substrat von dem Typ Silizium-auf-Isolator (SOI) ist und eine unter der siliziumbasierten Schicht der Dicke e eingegrabene Oxidschicht umfasst.

## Claims

1. A method for forming crystalline SiC-based zones on either side of an N-type transistor channel, comprising:
- Providing a substrate (10) comprising a silicon-based layer having a thickness e,
- Forming at least one masking pattern (20) on the silicon-based layer, of at least one masking pattern having openings, said openings corresponding to implantation zones for the silicon-based layer,
- Amorphising the silicon-based layer through the openings of the at least one masking pattern, in the implantation zones, to a depth d that is strictly less than the thickness e, so as to form amorphised implantation zones (132) in the silicon-based layer,
- Implanting carbon in the amorphised implantation zones (132),
- Performing recrystallisation thermal annealing so as to transform the amorphised implantation zones into crystalline SiC-based zones, the method further comprising:
- After forming the crystalline SiC-based zones, forming a transistor gate (30) on the silicon-based layer, directly at the edge of the crystalline SiC-based zones.

2. The method according to the preceding claim, further comprising forming spacers on either side of the transistor gate, at least in part on the crystalline SiC-based zones.

3. The method according to any one of the preceding claims further comprising epitaxially forming raised source and drain zones on the crystalline SiC-based zones.

4. The method according to any one of the preceding claims, wherein the at least one masking unit is based on a silicon nitride and silicon oxide bilayer.

5. The method according to any one of the preceding claims, wherein the at least one masking pattern is removed before forming the transistor gate.

6. The method according to any one of claims 1 to 4, wherein the at least one masking pattern is retained so as to form a sacrificial gate.

7. The method according to the preceding claim, further comprising forming spacers on either side of the sacrificial gate, at least in part on the crystalline SiC-based zones.

8. The method according to the preceding claim further comprising, after forming the spacers, removing the sacrificial gate followed by forming the transistor gate.

9. The method according to any one of claims 6 to 8, further comprising a step of forming insulation trenches before forming the at least one masking pattern.

10. The method according to any one of claims 6 to 9, wherein the at least one masking unit is based on a polycrystalline silicon and silicon oxide bilayer.

11. The method according to any one of the preceding claims, wherein the thickness e of the silicon-based layer and the amorphisation depth d are such that e - d ≥ 2 nm.

12. The method according to the preceding claim, wherein the amorphisation depth d is less than or equal to 20 nm.

13. The method according to any one of the preceding claims, wherein carbon is implanted to an implantation depth that is less than or equal to the amorphisation depth d.

14. The method according to any one of the preceding claims, wherein the amorphisation is carried out by implanting heavy ions such as germanium.

15. The method according to any one of the preceding claims wherein the substrate is of the silicon-on-insulator (SOI) type and comprises an oxide layer buried under the silicon-based layer having thickness e.
